# EUROPEAN PATENT APPLICATION

(11) **EP 4 340 552 A1**
(43) Date of publication of application: **20.03.2024**
(21) Application number: 22195386.2
(22) Date of filing: 13.09.2022
(51) Int. Cl.: H05K 3/12

(54) **LASER-INDUCED FORWARD TRANSFER METHOD AND DEVICE**

(71) Applicant: MYCRONIC AB, 183 03 Täby (SE)
(72) Inventor: Mårtensson, Gustaf, 170 74 Solna (SE); Leal, Jeff, 113 55 Stockholm (SE); Emthén, Anders, 194 68 Upplands Väsby (SE)
(74) Representative: AWA Sweden AB

(57) **Abstract**

A device (100) for depositing a donor material (130) on a workpiece (20) by laser-induced forward transfer (LIFT). The device comprises a light transmissive donor substrate (110) having a first side (112) configured to receive an impinging laser beam (140, 142) and a second side (114), opposing the first side. A layer (120) is arranged on the second side of the donor substrate. The layer comprises a plurality of apertures (122) exposing the underlying donor substrate. Each aperture defines a recess (124) configured to accommodate the donor material. The recess defines a volume of the donor material released onto the workpiece in response to the laser beam impinging the recess through the light transmissive donor substrate.

## Description

### Technical field

The present disclosure relates generally to the field of laser-induced forward transfer (LIFT). In particular, it relates to a device for depositing a viscous donor material on a workpiece by laser-induced forward transfer.

### Technical background

Methods are known in the art for depositing droplets of viscous medium, such as solder paste or an adhesive, onto a workpiece or a substrate. For example, the viscous medium may form deposits on the workpiece onto which different components may be mounted.

High production accuracy and reliability are factors of interest when manufacturing, e.g., printed circuit board (PCB) assemblies. In particular, the reliability, such as the accuracy and repeatability of the depositing process, is of interest due to its effects on the performance and the quality of the final product, for example a PCB assembly. Too small volumes of deposited medium may lead to, e.g., dry joints or loosening components, whereas too large volumes of deposited medium may result in short-circuiting caused, for example, by solder balls, or defective contacts due to contamination of adhesive or underfill.

Laser-induced forward transfer (LIFT) is a digital printing technique which may be used for depositing viscous medium onto a workpiece. A translucent or transparent donor substrate is coated with a thin layer of donor material, and a pulsed laser beam is used to transfer a portion of the donor material in the forward laser direction onto a receiving substrate (workpiece) to form a deposit. However, with the current drive toward ever smaller components, the size of deposits will need to decrease further, which will put further limitations on thickness and uniformity of the layer of donor material. Especially for suspensions like solder paste, there may be an implicit difficulty to provide a uniform and thin layer of donor material.

Further, using conventional/traditional LIFT devices, a part of the laser energy is used to separate the portion of material from the surrounding donor material layer.

Thus, there is still a need for an improved and efficient LIFT device and method enabling uniform and/or repeatable deposits.

### Summary

It is an object of the present invention to provide a method and a device overcoming, or at least alleviating, the above-mentioned drawbacks. In particular, it may be desirable to enable uniform deposits of a donor material on a workpiece by laser-induced forward transfer.

To better address one or more of these concerns, a device, a method, and an apparatus having the features defined in the independent claims are provided. Other embodiments are defined in the dependent claims.

Hence, according to a first aspect of the present disclosure, a device for depositing a donor material in on a workpiece by laser-induced forward transfer (LIFT) is provided. The device comprises a light transmissive donor substrate having a first side configured to receive an impinging laser beam and a second side, opposing the first side. A layer is arranged on the second side of the donor substrate. The layer comprises a plurality of apertures exposing the underlying donor substrate. Each aperture defines a recess configured to accommodate the donor material. The recess defines a volume of the donor material released onto the workpiece in response to the laser beam impinging the recess through the light transmissive donor substrate.

According to a second aspect of the present disclosure, there is provided a method for depositing a donor material in a pattern on a workpiece by laser-induced forward transfer (LIFT). The method comprises directing a laser beam onto a first side of a light transmissive donor substrate and through an aperture in a layer arranged on a second side of the light transmissive donor substrate, opposing the first side. The aperture defines a recess configured to accommodate and define a volume of the donor material released onto the workpiece. The method further comprises releasing the donor material onto the workpiece in response to the laser beam impinging the recess in the layer through the light transmissive donor substrate.

According to a third aspect of the present disclosure, there is provided a laser-induced forward transfer (LIFT) apparatus for depositing a donor material in a pattern on a workpiece. The apparatus comprises a laser device configured to generate a laser beam, a first holding device for holding the workpiece, and a second holding device for holding a light transmissive donor substrate. The light transmissive donor substrate has a first side and a second side opposing the first side. On the second side of the light transmissive donor substrate, a layer is arranged. The layer comprises a plurality of apertures exposing the underlying donor substrate. Each of the plurality of apertures defines a recess configured to accommodate the donor material. The apparatus is configured to direct the laser beam onto the first side of the donor substrate, such that the laser beam passes through the donor substrate and impinges the recess. The recesses are each configured to define a volume of the donor material released onto the workpiece in response to the laser beam impinging the recess.

An aperture may be an opening (or a hole) in the layer. The aperture may be defined by a cross-section of the opening, or an aperture area. The aperture area may be equivalent to an exposed area of the underlying donor substrate. Apertures may have different shapes and sizes. The shape and size of the aperture may define the surface area of the donor material being exposed by the laser beam.

The aperture and the underlying donor substrate may together form the recess. The recess may define a volume formed by the aperture and the underlying donor substrate. The recess may define an amount or volume of donor material which can be accommodated in the recess. A depth of the recess may be determined by a thickness of the layer.

The devices, methods, and apparatuses according to the present disclosure may increase the repeatability and/or uniformity of deposits formed on the workpiece, as the amount of material to be released onto the workpiece is defined by a recess in the layer on the donor substrate. Further, depending on, e.g., the viscosity of the donor material, the distance between the donor substrate and the workpiece, the size of the aperture, the resulting deposits may retain the shape of the aperture in varying degree.

Further, the different aspects of the present disclosure may facilitate forming deposits in a predetermined pattern on the workpiece. A pattern may, e.g., be defined by the placement and size of the recesses/apertures in the layer on the workpiece.

As the donor material is accommodated in the recesses in the layer, a laser having a wider footprint than the desired deposit may be used, such that a plurality of apertures/recesses may be impinged at the same time. This may provide that several recesses may be emptied using a single pulse of the laser. Thus, aspects of the present disclosure may further improve the speed and/or efficiency of forming deposits.

Moreover, accommodating donor material in the recesses in the layer may further provide that less laser energy is required to detach the amount of donor material from the donor substrate as the adhesion between the donor material and the layer may be smaller than the cohesion and surface tension of a continuous donor material layer.

Providing the donor material in recesses formed by the layer and the donor substrate may further bring that the volume of the donor material to be deposited onto the workpiece is defined and contained by the recesses. Thus, less waste of donor material may be achieved, which in turn may result in higher yield and improved efficiency.

The light transmissive donor substrate may for example be a substrate made of, e.g., glass, polymethyl methacrylate (PMMA), or typically any kind of substrate which allows transmission of light. Specifically, the donor substrate may be transmissive for the laser light received at the first side.

The workpiece may, for example, be a semiconductor wafer, or a sheet of metal or plastic suitable for receiving the donor material.

The donor material may be a viscous medium such as a solder paste or an adhesive.

The layer arranged on the second side of the donor substrate may for example be a layer, a sheet, or a coating. The layer may be designed and/or produced independently of the donor substrate. The layer may have different optical properties than the donor substrate.

According to some embodiments, the layer may be formed as a separate element and attached to the donor substrate.

In other words, the light blocking layer may be manufactured independently, and then attached to (arranged on) the donor substrate.

The apertures in the layer (and thus the recesses) may be formed when the layer is arranged on the second side of the donor substrate or formed prior to attaching/arranging the layer on the second side of the donor substrate.

In some embodiments, the donor substrate may be fixedly (or permanently) embedded with the layer. In such embodiments, the donor substrate and the layer may be manufactured together. Alternatively, the donor substrate and the layer may be manufactured separately and then fixed (permanently) to each other.

According to some embodiments, the layer may be formed by depositing a coating of layer material onto the donor substrate.

The coating may be formed as a uniform coating, followed by formation of the apertures using any suitable method, e.g., etching. Alternatively, the coating may be formed selectively on the donor substrate, using e.g., 3d printing techniques, to form the coating and apertures together.

According to some embodiments, the layer may be detachable and/or removable from the donor substrate.

The layer may maintain its structure after detaching and may therefore be reusable. Alternatively, the layer may be removable without maintaining its structure, for example by dissolving, grinding, etching, etc.

According to such embodiments, the donor substrate may be used together with different layers which define different apertures. Thus, the donor substrate may be reused, and the layer defining the apertures may be replaced to define different volumes or positions of the donor material to be deposited on the workpiece.

Detachable/removable layers may facilitate cleaning of the donor substrate and/or the apertures of the layer.

According to some embodiments, the layer may be at least partially light-blocking.

A light-blocking layer (of a light blocking material) can have a light-absorbing or light-reflecting properties.

An at least partially light-blocking layer may at least partially block light from passing through from one side of the layer to other side. The use of an at least partially light-blocking layer may partially or fully protect the workpiece from exposure to the laser beam. Further, an at least partially light-blocking layer may protect, e.g., the workpiece when using a laser with a footprint larger than a single aperture. For a single laser beam, the laser intensity may vary across the illuminated surface. For example, the irradiance profile of a laser beam is often assumed to follow a Gaussian distribution. Although solutions exist to increase the sharpness of the irradiance profile, the edges of the irradiance profile are often blurred. Using a laser with a footprint (profile) larger than an aperture may provide a more uniform laser intensity across the aperture.

According to some embodiments, a width to depth ratio of the apertures may be less than or equal to 1.

In other words, the thickness of the layer may be larger than the width of the aperture.

According to some embodiments, the width to depth ratio (w : d) of the apertures may be greater than 1.

In other words, the aperture may be wider than the thickness of the layer.

The width of a non-circular aperture may be defined as a longest distance between two opposite sides of the aperture. Alternatively, the width may be calculated as mean or median of more than one distance measured across the aperture.

The width-to-depth ratio of an aperture may affect the shape of the resulting deposit on the workpiece. For example, a deposit formed on the workpiece using a recess having a lower width to depth ratio may have a lower width-to-depth ratio than a deposit formed using a recess with higher width-to-depth ratio. In other words, a lower width-to-depth ratio of the recess may provide a higher deposit, while a recess having a higher width-to-depth ratio may provide a lower (flatter) deposit.

According to some embodiments, sidewalls of the aperture may be parallel or tapered.

The shape of the sidewalls of the aperture may affect the deposit formation and the directed release of the donor material onto the workpiece. The shape of the sidewalls may also affect the amount of laser energy required for releasing the donor material from the recess.

The sidewalls of the recess may be tapered in a direction towards the underlying donor substrate or away from the underlying donor substrate.

For example, when the sidewalls of the recess taper towards the underlying donor substrate, i.e., when the sidewalls diverge in a direction away from the underlying donor substrate, less laser energy may be required to release the material in the recess. For example, the diverging sidewalls of the recess may decrease the hydrodynamic resistance of the material inside the recess.

Alternatively, embodiments in which the sidewalls taper away from the underlying donor substrate, i.e., when a cross-section of the aperture is the largest at the donor substrate, a larger portion of the material in the recess may be activated by the laser. As a result, a momentum and/or precision of released droplets may increase.

According to some embodiments, the method may further comprise replenishing at least one recess with donor material after releasing the donor material onto the workpiece. Replenishment allows reuse of the layer, which may improve efficiency and reduce cost.

According to some embodiments, the replenishment may comprise wiping the donor material over the layer arranged on the second side of the donor substrate.

The layer or the complete device may be transferred to a replenishment station for refilling the empty recesses with the donor material.

Alternatively, the layer may be disposable, such that it can be used once for depositing donor and then replaced by, e.g., another disposable layer.

According to some embodiments, the second holding device of the apparatus may be configured to hold at least two light transmissive donor substrates. Each of the donor substrates may be used one at a time for depositing the donor material.

For example, one of the donor substrates may be used for depositing the donor material, while the other donor substrate may be refilled with donor material and vice versa.

According to some embodiments, the apparatus may further comprise a replenishment station configured to replenish the donor substrate with the donor material.

According to some embodiments, the replenishment station may be configured to replenish a donor substrate with the donor material while another donor substrate is used for depositing the donor material on the workpiece.

This may allow the process of depositing the donor material on the workpiece to continue without (or at least with less) interruption. When one of the donor substrates is being replenished with the donor material, the other donor substrate may still be in use for depositing donor material on the workpiece, and vice versa.

It is noted that embodiments of the invention relate to all possible combinations of features recited in the claims. Further, it will be appreciated that the various embodiments described for the device, in accordance with the first aspect of the disclosure, are all combinable with embodiments of the method and the apparatus as defined in accordance with the second and third aspects, and vice versa. For example, the apparatus of the third aspect of the disclosure may be configured to operate in accordance with the method of the second aspect of the disclosure. The apparatus of the third aspect of the disclosure may be configured to include or use a device in accordance with the first aspect of the disclosure.

### Brief description of the drawings

These and other aspects will now be described in more detail with reference to the appended drawings showing embodiments.
Figure 1 shows a cross-sectional view of a device for depositing a donor material on a workpiece by laser-induced forward transfer (LIFT) according to some embodiments;
Figure 2 shows a flowchart illustrating a method for depositing donor material on the workpiece by laser-induced forward transfer (LIFT) in accordance with some embodiments;
Figure 3 shows a device, in accordance with some embodiments, viewed from below;
Figure 4 shows a device, in accordance with some embodiments, having apertures of different sizes;
Figures 5a and 5b show cross-sectional views of devices in which the aperture sidewalls are tapered, in accordance with some embodiments;
Figure 6 shows a LIFT apparatus for depositing the donor material on the workpiece, in accordance with some embodiments;
Figure 7 shows a LIFT apparatus for depositing the donor material on the workpiece, in accordance with some embodiments.

All the figures are schematic, not necessarily to scale, and generally only show parts which are necessary in order to elucidate the embodiments, wherein other parts may be omitted or merely suggested. Like reference numerals refer to like elements throughout the description.

### Detailed description

The present aspects will now be described more fully hereinafter with reference to the accompanying drawings, in which currently preferred embodiments are shown. This invention may, however, be embodied in many different forms and should not be construed as limited to the embodiments set forth herein; rather, these embodiments are provided for thoroughness and completeness, and fully convey the scope of the present aspects to those skilled in art.

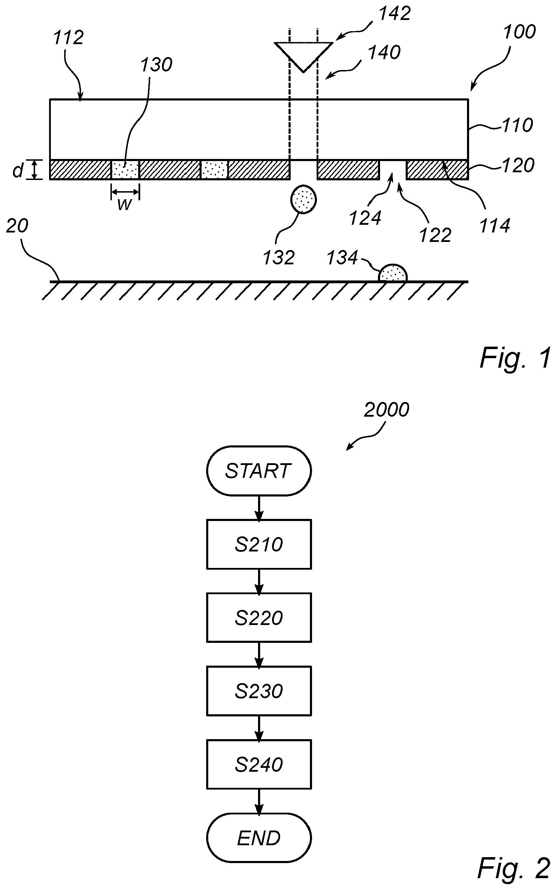

With reference to Figure 1, a device in accordance with some embodiments will be described.

Figure 1 illustrates a cross-sectional view of a device 100 in operation. In Figure 1, the device 100 is used to deposit a donor material 130 on a workpiece 20 by laser-induced forward transfer (LIFT). The device 100 includes a light transmissive donor substrate 110 having a first side 112 and a second side 114. The first side 112 of the light transmissive donor substrate 110 is configured to receive an impinging laser beam 140, and the second side 114 is opposing the first side 112. The light transmissive donor substrate 110 may be a substrate made of, e.g., glass, polymethyl methacrylate (PMMA), or any kind of substrate which allows light to pass through.

The second side 112 of the donor substrate 110 is arranged with a layer 120. The layer 120 may be made of a material having light blocking characteristics. Alternatively, layer 120 may be light transmissive. The layer 120 may be formed as a separate element attached to the donor substrate 110. Alternatively, the layer 120 can be formed by a coating of light blocking material or light transmissive material on the light transmissive donor substrate 110. The layer 120 comprises a plurality of apertures 122 exposing the underlying donor substrate 110. In Figure 1, the plurality of apertures 122 are of the same shape and size, having a width, w. The depth of the apertures is defined by the thickness, d, of the layer 120. Together with the donor substrate 110, each aperture 122 defines a recess 124 configured to accommodate a volume of donor material.

With reference to Figure 1 and Figure 2 together, a method for depositing a donor material on a workpiece (20) by laser-induced forward transfer, LIFT, will be described.

Figure 2 is a flowchart illustrating a method 2000 for depositing a donor material on the workpiece 20 by laser-induced forward transfer (LIFT) using the device 100.

Before use, the recesses 124 of the device 110 are filled with donor material 130. Figure 1 illustrates the device 100 during use. In Figure 1, the recesses 124 at one end of the layer 120 are filled with donor material. While at the other end of the layer 120, the recesses 124 are empty, as the donor material has already been released from the recess 124 towards the workpiece 20.

At step S210, the device 100 is arranged with respect to the workpiece 20 such that the apertures 122 are aligned to position on the workpiece 20 where donor material 130 is to be deposited.

After the device 100 is aligned with the workpiece 20, at the next step S220, a laser beam 140, or a laser pulse 142, is directed toward at least one recess/aperture 124/122, in which donor material 130 is accommodated. The laser beam/pulse 140/142 enters the donor substrate 110 through the first side 112 and is transmitted through the donor substrate 110 to the second side 114. As the laser beam/pulse 140/142 reaches the recess 124, the energy is transferred to the donor material 130 accommodated therein. Due to the energy transfer, evaporation, or sublimation of the donor material 130 may take place.

As a result of the energy transfer, at step S230, donor material 132 is released from the recess 124 and projected towards the workpiece 20, on which it forms a deposit 134.

In Figure 1, the laser beam 140 is illustrated as having a similar width to the apertures 122. However, the laser beam 140 and/or pulse 142 may have a width wider than the aperture 122. For example, the laser may have a width wide enough to cover more than one aperture 122/recess 124, such than more than one deposit 134 may be formed at once. In some embodiments, more than one laser beam 140 or pulse 142 may be used.

Further, as the material 130 to be deposited is already defined by the recesses 124, the width or shape of the laser beam 140 or pulse 142 does not have to be adapted to each individual deposit.

The layer 120 may be (at least partially) light blocking. Using a light-blocking layer may protect the workpiece, and any sensitive components thereon, from the laser beam 140 or pulse 142. Further, if there is any excess donor material present on the layer 130, e.g., between the apertures, a light-blocking layer 120 may prevent the excess material from being deposited on the workpiece.

In some embodiments, the empty recesses 124 may be replenished after deposition of the donor material 130, at step S240 of the method 2000. Thus, the layer 120 could be reused multiple times.

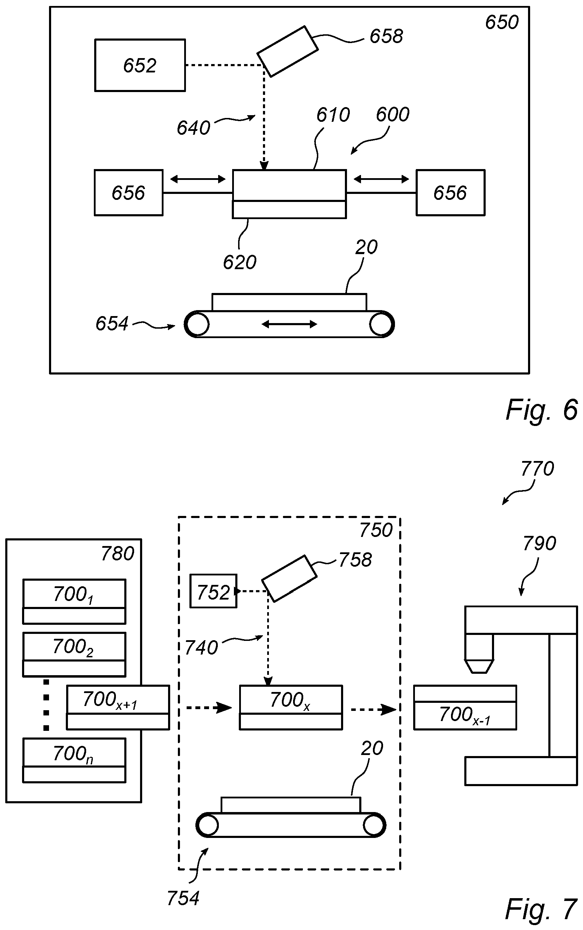

The replenishment of donor material could be done in various ways. For example, the replenishment could take place while the layer is attached to the donor substrate 110. Alternatively, the layer 120 may be detached from the donor substrate 110, and apertures 112 may be replenished while the layer 120 is detached from the donor substrate 110. Replenishment will be discussed further below, with reference to Figure 7.

The method steps described above may be repeated until a pre-defined pattern of deposits has been formed on the workpiece 20.

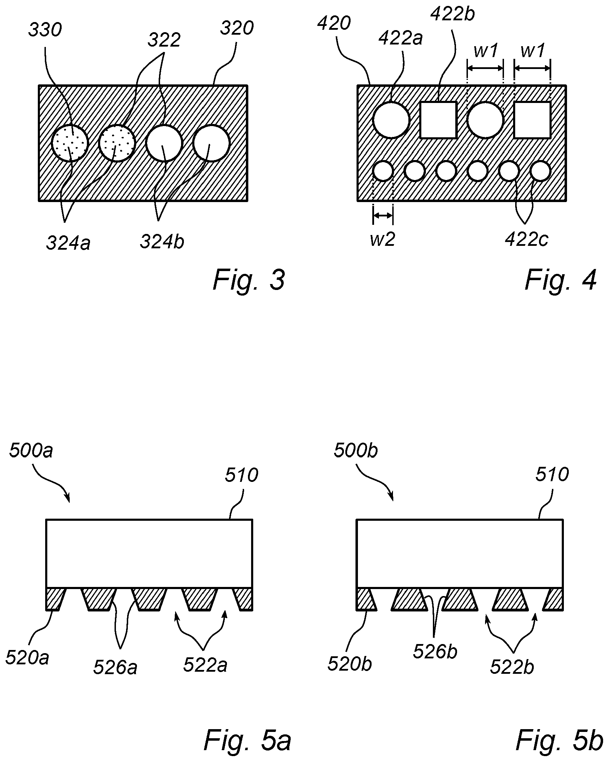

With reference to Figures 3-5, the layer 120 and apertures 122 will be further described.

In Figure 3, a device similar to the one described with reference to Figure 1 is illustrated viewed from below, i.e., from the side of workpiece 20 or from the side opposite to the impinging laser beam. A layer 320 is shown comprising a plurality of apertures 322. The recesses 324a on one end of the layer 320a are filled with donor material 330, while the recesses 324b at the other end of the layer are empty.

The apertures 322 illustrated in Figure 3 are all of the same size, and all have a circular cross-section. However, as is illustrated in Figure 4, the apertures may have different shapes and sizes. The apertures 322 may form a specific pattern, which may be designed such that the resulting deposits form a desired pattern on the workpiece.

Figure 4 is an illustration of a layer 420. The layer 420 may be equivalent to the layer 120 and/or the layer 320, described above with reference to preceding Figures, except in that its apertures 422a-c have different shapes and sizes. Specifically, the layer 420 has a first sequence of apertures 422a-b with a constant width, w1, and a second sequence of apertures 422c with a constant width, w2, different from w1. Further, the first sequence of apertures comprises both circular apertures 422a and square apertures 422b. It will be appreciated that apertures may have further different shapes, such as oval, hexagonal, or any other shape as per the requirements of a design for the workpiece.

Figures 5a, and 5b show cross-sectional views of a device 500a, 500b, comprising a donor substrate 510 and a layer 520a, 520b. The devices 500a, 500b may be equivalent to the device 100 described above with reference to Figure 1, except that the sidewalls 526a, 526b of the apertures 522a, 522b, are non-parallel.

In both Figure 5a and 5b the apertures 522a, 522b have tapered sidewalls. In Figure 5a, thesidewalls 526a of the apertures 522a taper away from the underlying donor substrate 510, In other words, the apertures 522a are narrow close to the donor substrate 510 and become wider further from the donor substrate 510. In Figure 5b, the sidewalls 526b of the apertures 522b taper in the direction towards the underlying donor substrate 510. In other words, the apertures 522b are widest at the donor substrate 510, giving the recesses formed by the apertures 522b and the underlying substrate 510 a narrower opening.

With reference to Figure 6, an apparatus 650 in accordance with some embodiments will be described.

Figure 5 is an illustration of a laser-induced forward transfer, LIFT, apparatus 650 for depositing a donor material on a workpiece 20. The apparatus 650 is configured to use a device 600, which may be equivalent to any of the devices 100, 500a, 500b described above with reference to the preceding figures. The apparatus 650 may be configured to operate in accordance with methods described throughout the present disclosure, as exemplified above with reference to Figure 2.

The LIFT apparatus 650 comprises a laser device 652 configured to generate a laser beam 640, and an optical arrangement 658 configured to direct the laser beam 658 to the donor substrate 610 of the device 600. The apparatus 560 further comprises a first holding device 654 for holding the workpiece 20, and a second holding device 656 for holding the device 600.

The first holding device 654 may, for example, be a conveyor belt, which positions the workpiece 20 at a desired location under the device 600. The second holding device 656 can be seen arranged on both sides of the device 600. The second holding device 656 may be capable of detecting the workpiece 20 and aligning the device 600 such that the apertures (not depicted) in the layer 620are aligned with corresponding positions on the workpiece 20.

The laser device 652 may comprise an optical or beam forming arrangement configured to generate a laser beam 640 or laser pulse. The apparatus 650 directs the laser beam 640 or laser pulse onto the first side of the donor substrate 610 using the optical arrangement. Alternatively, laser device 652 may emit the laser beam 640 or laser pulse directly onto the first side of the donor substrate 610.

With reference to Figure 7, a further embodiment of an apparatus 770 will be described.

Figure 7 is an illustration of an apparatus (or a system) 770 . The apparatus 770 comprises a LIFT apparatus 750 which may be equivalent to the apparatus 650 described with reference to Figure 6. The apparatus 770 further comprises a stacking unit 780,

The stacking unit 780 can accommodate a plurality of devices 700₁-700ₙ. The recesses devices 700₁-700ₙ may be prefilled with donor material. Alternatively, the stacking unit may comprise a plurality of layers, with or without prefilled apertures, for attaching to a donor substrate.

When the apparatus 770 is operational, a first device 700ₓ of the plurality of devices 700₁-700ₙ is fetched from the stacking unit 780 for deposition of donor material onto the workpiece 20. Deposition may for example be performed as described above with reference to preceding figures, and/or in accordance with methods described throughout the present disclosure.

The apparatus 770 further comprises a replenishment station 790. After deposition of the donor material in the recesses of the layer, the first device 100ₓ may then be sent to the replenishment station 790 of the apparatus for refilling the recesses with the donor material. Meanwhile, a second device 700ₓ₊₁ from the stacking unit 790 may be fetched and arranged in the apparatus 750 to continue deposition of donor material on the same workpiece 20, or a different workpiece. After the recesses of the first device 100ₓ have been replenished, the first device 100ₓ may be transferred to the stacking unit 780 for reuse.

Different methods for filling recesses with viscous material are known in the art. For example, the donor material may be applied to a side of the layer, and then squeezed into the recesses by spreading the donor material using a squeegee, blade, or roller. Any excess donor material left on the layer may be scraped off.

As is illustrated in Figure 7, the replenishment station 790 and the LIFT apparatus 750 may operate concurrently, or independently. While one device 700ₓ is being used for deposition of donor material onto the workpiece, a second device 700ₓ₋₁ may be replenished at the replenishment station 790.

While the present embodiment describes the transfer of the entire device 700 to the replenishment station 790, it will be appreciated that a similar operation may be performed by transferring only the layer of the device to the replenishment station, while keeping the donor substate fixed at the workstation of the apparatus750.

It will further be appreciated that the apparatus 750 and optionally the stacking unit 780 may be compatible with the use of disposable devices, or devices with disposable layers.

The person skilled in the art realizes that the present invention by no means is limited to the preferred embodiments described above. On the contrary, many modifications and variations are possible within the scope of the appended claims.

Additionally, variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. An apparatus 650 as defined in the claims, may be directed to perform a particular routine by a programmable device, for example, by directing the laser beam on specified apertures, as required for a particular electronic design to be printed on the workpiece. A computer program may be stored/distributed on a suitable medium, such as an optical storage medium or a solid-state medium supplied together with or as part of other hardware, but may also be distributed in other forms, such as via the Internet or other wired or wireless telecommunication systems. The mere fact that certain measures are recited in mutually different dependent claims does not indicate that a combination of these measured cannot be used to advantage. Any reference signs in the claims should not be construed as limiting the scope.

## Claims

1. A device (100) for depositing a donor material on a workpiece (20) by laser-induced forward transfer, LIFT, the device comprising:
a light transmissive donor substrate (110) having a first side (112) configured to receive an impinging laser beam and a second side (114), opposing the first side;
a layer (120) arranged on the second side of the donor substrate, the layer comprising a plurality of apertures (122) exposing the underlying donor substrate,
wherein each aperture defines a recess (124) configured to accommodate the donor material (130), and
wherein the recess defines a volume of the donor material released onto the workpiece in response to the laser beam impinging the recess through the light transmissive donor substrate.

2. The device according to claim 1, wherein the layer is formed as a separate element attached to the donor substrate.

3. The device according to claim 1, wherein the layer is formed by depositing a coating of a layer material onto the donor substrate.

4. The device according to any of the preceding claims, wherein the layer is detachable and/or removable from the donor substrate.

5. The device according to any of the preceding claims, wherein the layer is at least partially light blocking.

6. The device according to any of the preceding claims, wherein a width (w) to depth (d) ratio of the apertures is less than or equal to 1.

7. The device according to any of claims 1-5, wherein a width to depth ratio of the apertures is greater than 1.

8. The device according to any of the preceding claims, wherein sidewalls (526a-b) of an aperture are parallel or tapered.

9. A method (2000) for depositing a donor material on a workpiece (20) by laser-induced forward transfer, LIFT, the method comprising:
directing (S220) a laser beam onto a first side (112) of a light transmissive donor substrate (110) and through an aperture (122) in a layer (120) arranged on a second side (114) of the light transmissive donor substrate, opposing the first side, wherein the aperture defines a recess (124) configured to accommodate and define a volume of the donor material (130) released onto the workpiece; and
releasing (S230) the donor material onto the workpiece in response to the laser beam impinging the recess in the layer through the light transmissive donor substrate.

10. The method according to claim 9, further comprising replenishing (S240) the recess with donor material after releasing the donor material onto the workpiece.

11. The method according to claim 10, wherein the replenishment comprises wiping the donor material over the layer.

12. A laser-induced forward transfer, LIFT, apparatus (650) for depositing a donor material on a workpiece (20), comprising:
a laser device (652) configured to generate a laser beam;
a first holding device (654) for holding the workpiece; and
a second holding device (656) for holding a light transmissive donor substrate (610) having a first side (112) and a second side (114), opposing the first side, on which a layer (120) is arranged, the layer comprising a plurality of apertures (122) exposing the underlying donor substrate and defining a recess (124) configured to accommodate the donor material (130);
wherein the apparatus is configured to direct the laser beam (640) onto the first side of the donor substrate, such that the laser beam passes through the donor substrate and impinges the recess; and
wherein the recess is configured to define a volume of the donor material released onto the workpiece in response to the laser beam impinging the recess.

13. The LIFT apparatus according to claim 12, wherein the second holding device is configured to hold at least two light transmissive donor substrates (700ₓ, 700ₓ₋₁, 700ₓ₊₁), such that each of the donor substrates is used one at a time for depositing the donor material.

14. The LIFT apparatus according to claim 12 or 13, further comprising a replenishment station (790) configured to replenish the donor substrate with donor material.

15. The LIFT apparatus according to claim 14, wherein the replenishment station is configured to replenish a donor substrate (700ₓ₋₁) while another donor substrate (700ₓ) is used for depositing the donor material on the workpiece.
